Europäisches Patentamt

European Patent Office

Office européen des brevets

(19)

(11) Veröffentlichungsnummer: **0 247 386 B1**

# (12) EUROPÄISCHE PATENTSCHRIFT

(45) Veröffentlichungstag der Patentschrift: 27.03.91

(21) Anmeldenummer: 87106346.7

(22) Anmeldetag: 02.05.87

(51) Int. Cl.⁵: **H01L 29/72**, H01L 27/06, H01L 21/82, H01L 29/10

(54) Lateraltransistor.

(30) Priorität: 30.05.86 DE 3618166

(43) Veröffentlichungstag der Anmeldung:
02.12.87 Patentblatt 87/49

(45) Bekanntmachung des Hinweises auf die
Patenterteilung:
27.03.91 Patentblatt 91/13

(84) Benannte Vertragsstaaten:
DE FR GB IT NL

(56) Entgegenhaltungen:
EP-A- 0 100 677
EP-A- 0 152 929
US-A- 4 283 236

PATENT ABSTRACTS OF JAPAN, Band 4, Nr.
162 (E-33) [644], 12. November 1980 & JP-
A-55-110 071

(73) Patentinhaber: TELEFUNKEN electronic GmbH
Theresienstrasse 2
W-7100 Heilbronn(DE)

(72) Erfinder: Arndt, Jürgen, Dr.
Im Dornberg 6
W-7101 Obergruppenbach(DE)

(74) Vertreter: Maute, Hans-Jürgen, Dipl.-Ing.
TELEFUNKEN electronic GmbH Theresienstrasse 2
W-7100 Heilbronn(DE)

**Beschreibung**

Die Erfindung betrifft einen PNP-Lateraltransistor aus zwei in die Oberfläche eines Halbleiterbereichs vom ersten Leitungstyp eingelassenen, Emitter und Kollektor bildenden Zonen vom zweiten Leitungstyp.

Ein derartiger Lateraltransitor ist aus US-A-4283 236 bekannt. Bei diesem bekannten Lateraltransistor wird durch Ionenimplantation ein Kontradotierter Bereich in der Basiszone erzeugt, der sich zwischen dem aktiven Basisbereich und dem Kollektor erstreckt und zur Reduzierung der aktiven Basisbreite dient.

Der Einsatz von lateralen PNP-Bipolartransistoren in bipolaren integrierten Schaltungen zur Ergänzung der vertikalen NPN-Transistoren ist bereits bekannt. Hierbei werden die Eigenschaften dieser Lateraltransistoren vor allem bezüglich Grenzfrequenz, Stromverstärkung und Rauschen deutlich hinter denen komplementärer vertikaler PNP-Transistoren zurückbleiben. Wegen der Kompatibilität des Herstellungsprozesses werden diese lateralen PNP-Transistoren aber zusammen mit vertikalen NPN-Transistoren in Integrierten Schaltungen weltweit eingesetzt.

In "IEEE Journal of Solid-State-Circuits" Vol. SC-18, No. 3, Juni 1983, S. 273 wird vorgeschlagen, N-Kanal-Feldeffekttransistoren als laterale NPN-Bipolartransistoren in einer P-Wannen-CMOS-Technologie einzusetzen. Dieser Vorschlag kann auch auf einen N-Wannen-CMOS-Prozeß übertragen werden, wobei die in der Wanne liegenden P-Kanal-Feldeffekttransistoren als laterale PNP-Transistoren eingesetzt werden.

Der Erfindung liegt die Aufgabe zugrunde, einen PNP-Lateraltransistor anzugeben, der entscheidend verbesserte Verstärkungseigenschaften gegenüber den oben erwähnten Lateraltransistoren aufweist und der sich in Verbindung mit dem Herstellungsverfahren von integrierten Schaltungen, die sowohl MOS-Feldeffekttransistoren als auch Bipolartransistoren enthalten, leicht herstellen läßt. Diese Aufgabe wird erfindungsgemäß durch die Merkmale im kennzeichen des Patentanspruchs 1 gelöst.

Der Erfindung liegt die Erkenntnis zugrunde, daß bei Lateraltransistoren nach dem erwähnten bekannten Konzept zwei Effekte für die schlechten Verstärkungseigenschaften der lateralen Transistoren verantwortlich sind. Dies sind:

1. Die starke Rekombination der Minoritätsladungsträger an der Oberfläche der Basis, an der Grenzfläche zwischen Isolationsoxid und einkristallinem Silizium, durch die dort vorhandenen geladenen und ungeladenen Oberflächenzustände und Traps.

2. Der grundsätzlich zu jedem Lateraltransistor paralleld liegende parasistäre Substrattransistor, der einen Teil des vom Emitter injizierten Minoritätenstromes ableitet.

Diese Nachteile werden nach der Erfindung dadurch beseitigt, daß eine Konzentration des Minoritätsstromes in der Basiszone zwischen Emitter und Kollektor erreicht wird, in Form eines bevorzugten Stromkanals. Dadurch wird der Einfluß der beiden parasitären Prozesse, Oberflächenrekombination einerseits und Substrat-Transistor andererseits, vor allem bei kleinen Strömen entscheidend vermindert.

Dieser Stromkanal mit geringerer Schwelle an der injizierenden Emitter-Basis-Sperrschicht wird durch die Implantation von Dotieratomen, welche in Richtung p-Leitung wirken, erzeugt. Die Implantationsenergie wird so gewählt, daß die Dotieratome in einem Abstand zur Oberfläche eingebaut werden, der etwa der Hälfte der senkrechten Ausdehnung der Emitterzone entspricht.

Die Dotierung der vergrabenen Halbleiterzone, die den Stromkanal bildet, wird beim PNP-Lateraltransistor so gewählt, daß in diesem Stromkanal eine Reduzierung der n-Dotierung oder gar eine schwache p-Umdotierung erfolgt, wobei die p-Dotierung jedoch so gewählt ist, daß keine Selbstleitung im Stromkanal erfolgt. Der erfindungsgemäße Lateraltransistor wird vorzugsweise mit CMOS-Feldeffekttransistoren und NPN-Bipolartransistoren in einem allen Bauelementen gemeinsamen Halbleiterkörper im Rahmen einer integrierten Halbleiterschaltung angeordnet. Bei der Herstellung des Lateraltransistors im Verbund mit CMOS-Feldeffekttransistoren erfolgt die Herstellung des vergrabenen Stromkanals durch die Ionenimplantation, mit der die Schwellspannung der Feldeffekttransistoren mittels Implantation von Ladungsträgern durch die jeweils die Halbleiteroberfläche bedeckende Gate-Isolierschicht eingestellt wird.

Ausführungsbeispiele der Erfindung werden nachstehend anhand der zeichnung näher erläutert.

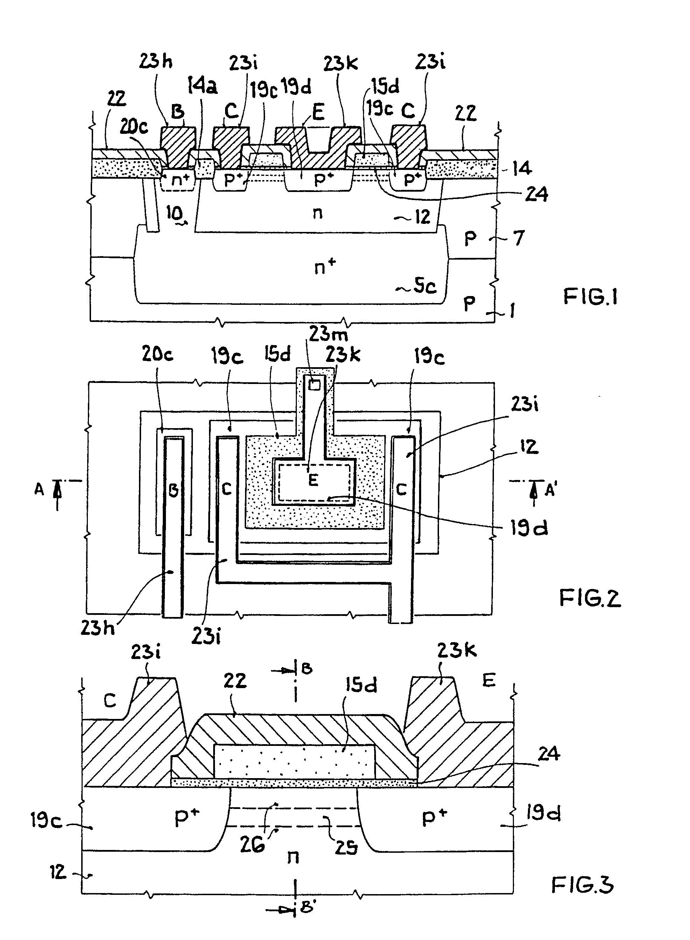

Hierbei zeigt die Figur 1 einen Schnitt durch einen Lateraltransistor nach einem Ausfürungsbeispiel der Erfindung entlang der Schnittlinie A-A' aus der Draufsichtdarstellung der Figur 2 .

Figur 3 zeigt einen wesentlichen Teilausschnitt aus der Figur 1.

Figur 4 zeigt schematisch zwei mögliche Dotierungsprofile durch die aktive Basiszone entlang der Schnittlinie B-B' gemäß Figur 3.

Die Figur 5 zeigt den Verlauf der Gleichstromverstärkung bei einem Lateraltransistor nach einem Ausführungsbeisiele der Erfindung im Vergleich zu Lateraltransistoren ohne vergrabenen Stromkanal.

Die Figuren 6a bis 6k dienen der Veranschaulichung der aufeinanderfolgenden Prozeßschritte bei der Herstellung einer integrierten Halbleiterschaltung, die sowohl CMOS-Feldeffekttransistoren als auch NPN-Vertikaltransistoren und PNP-Lateraltransistoren nach der Erfindung enthält.

Die Figuren sind schematisch und nicht maßstäblich gezeichnet. Entsprechende Teile sind in den Figuren mit den gleichen Bezugsziffern bezeichnet.

Die Figur 1 zeigt im Schnitt einen Lateraltransistor nach einem Ausführungsbeispiele der Erfindung, der in der Figur 2 in der Draufsicht dargestellt ist. Der Schnitt nach der Figur 1 ist durch die Linie A-A' in Figur 2 definiert. Die Anordnung weist einen einkristallinen Halbleiterkörper 1 vom p-Leitfähigkeitstyp auf, der durch eine niedrigdotierte epitaktisch aufgebrachte Halbleiterschicht 7 ebenfalls vom p-Leitfähigkeitstyp ergänzt wird. Zwischen beiden ist lokal ein vergrabenes Gebiet 5c vom hochdotierten n-Leitungstyp eingebracht. Oberhalb und anschließend an dieses vergrabene Gebiet sowie angrenzend an die Halbleiteroberfläche, liegt ein n-dotiertes Gebiet 12, welches im folgenden als n-Wanne bezeichnet wird.

In dieser n-Wanne 12 sind angrenzend an die Halbleiteroberfläche eine p$^+$-leitende Emitterzone 19d und konzentrisch dazu eine p$^+$-leitende Kollektorzone 19c angeordnet. Zwischen beiden ist auf der Halbleiteroberfläche eine ringförmige Gateelektrodenschicht 15d, beispielsweise aus polykristallinem Silizium angeordnet, die durch eine Schicht 24, beispielsweise aus Siliziumdioxid, von dem Halbleiterkörper getrennt ist.

Die Anordnung enthält weiter ein wenigstens teilweise in das Silizium versenktes Muster 14 aus elektrisch isolierendem Material, in diesem Beispiel Siliziumdioxid. Dieses begrenzt das n-Wannengebiet 12 vollständig und sorgt für die Trennung von Basisanschlußgebiet 20c und Kollektorgebiet 19c. Die n$^+$-leitende Basisanschlußzone 10 ist in der Wanne 12 seitlich von der Transistorstruktur und von dieser durch den isolierenden Teilbereich 14a an der Halbleiteroberfläche getrennt angeordnet, wobei sich diese Anschlußzone 10 bis in die vergrabene Schicht 5c erstreckt. Der Basisanschlußkontakt ist mit 23h, der konzentrische Kollektoranschluß mit 23i und der Emitteranschlußkontakt mit 23k bezeichnet. Zwischen der Gateelektrode 15d, die beim PNP-Lateraltransistor nach einem Ausführungsbeispiele der Erfindung mit dem Emitteranschluß 23m verbunden ist und den genannten Anschlußkontakten takten 23h bis 23k befindet sich eine vorzugsweise aus der Gasphase abgeschiedene Isolierschicht 22, die beispielsweise aus hochdotiertem Phosphorglas besteht.

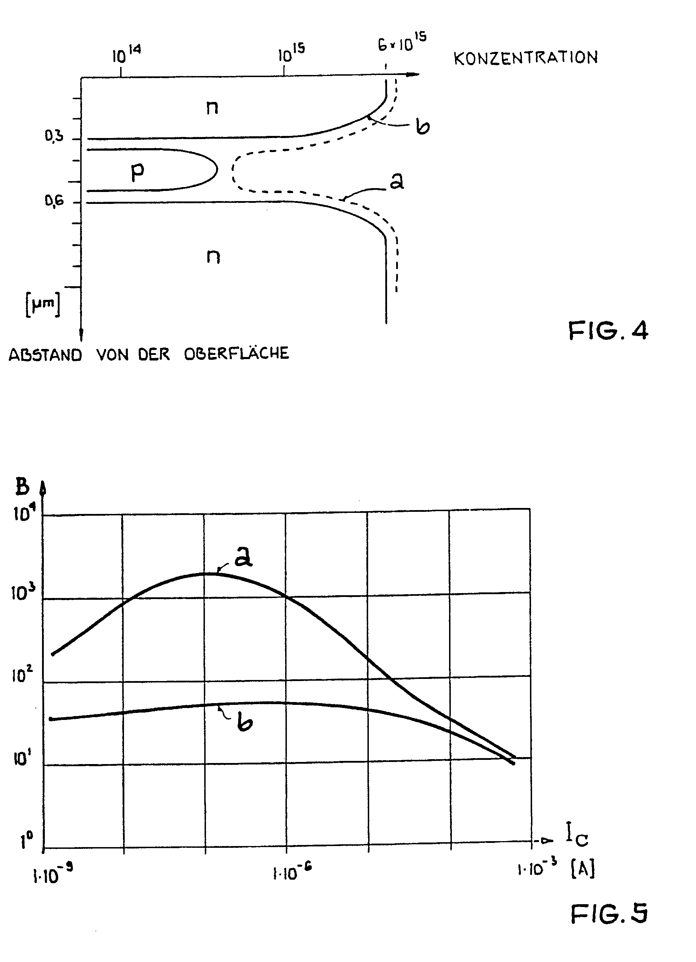

Wesentlich für die Eigenschaften des erfindungsgemäßen PNP-Lateraltransistors ist die zwischen Emitterzone 19d und Kollektorzone 19c eingebrachte vergrabene Halbleiterzone 25, die in der Ausschnittdarstellung in Figur 3 deutlich erkennbar ist.

Diese Halbleiterzone 25 enthält zusätzliche p-Leitfähigkeit verursachende Verunreinigungen, beispielsweise Bor, welche die n-Leitfähigkeit der Basiszone 26 in einem ringförmigen Bereich 25 vermindern bzw. zur p-Leitfähigkeit umdotieren. Zwei geeignete schematische Dotierungsprofile a bzw. b entlang der Schnittlinie B-B' in Fig. 3 zeigt Fig. 4.

Beim Dotierungsprofil a wird in der vergrabenen Zone 25, die den Stromkanal für die Minoritätsladungsträger bildet, die Dotierung von $6 \times 10^{15}$ Atome/cm$^3$ über und unter dem Stromkanal auf ca. $5 \times 10^{14}$ Atome/cm$^3$ reduziert. Beim Dotierungsprofil b erfolgt eine schwache Umdotierung zur p-Leitfähigkeit, wobei jedoch die p-Dotierung so gering ist, daß kein selbstleitender MOS-Feldeffekttransistor entsteht. Dies bedeutet, daß bei der Spannung 0 an der Gateelektrode 15d keine Leitung im Stromkanal 25 herbeigeführt wird. Dies ist notwendig, da der parasitäre p-Kanal MOS-Transistor mit der Sourcezone 19d, der Drainzone 19c und der Gateelektrode 15d vom selbstsperrenden Typ, mit einer Schwellenspannung von $U_{TH}$ - 0,8 V sein muß. Hieraus ergibt sich auch eine natürliche Grenze für die Menge der z.B. per Ionenimplantation eingebrachten, p-Leitfähigkeit verursachenden Verunreinigungen im Stromkanal 25. Beim Ausführungsbeispiel b nach der Figur 4 beträgt die p-Dotierung im Stromkanal ca. $5 \times 10^{14}$ Atome/cm$^3$.

Nach der Erfindung wird folglich in der aktiven Basiszone 26 zwischen der Emitterzone 19d und der Kollektorzone 19c ein vergrabener Stromkanal 25 für die in der Basis als Minoritätsstrom fließenden positiven beweglichen Ladungsträgern (Löcher) geschaffen.

Durch die Verbindung der Gateelektrode 15d mit dem Emitteranschluß ist außerdem sichergestellt, daß ein parasitärer Strom zwischen der Emitterzone und der Kollektorzone aufgrund eines leitenden Feldeffekttransistors verhindert wird.

Figur 5 zeigt im Vergleich den schematischen Verlauf der Gleichstromverstärkung B in Emitterschaltung über dem Kollektorstrom $I_c$ für einen lateralen PNP-Transistor entsprechend einem Ausführungsbeispiel nach der Erfindung (Kurve a) und einem entsprechenden Transistor ohne die Halbleiterzone 25 zwischen Emitter und Kollektor (Kurve b). Das Halbleiterbauelement nach der Erfindung hat eine um mehr als eine Größenordnung höhere Stromverstärkung bei Strömen kleiner als 1 μA. Durch die Ausschaltung des Einflusses der Oberfläche sind auch die Rauscheigenschaften in diesem Strombereich deutlich verbessert. Daraus ergibt sich ein vorteilhafter Anwendungsbereich in leistungs- und rauscharmen Eingangsverstärkern.

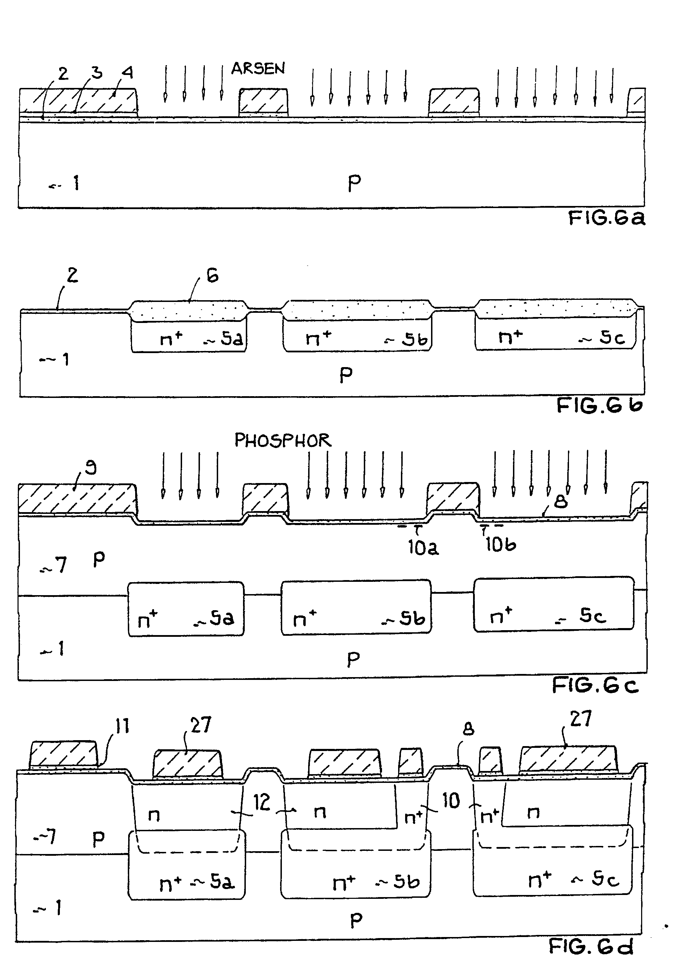

Der beschriebene laterale PNP-Bipolartransistor kann vorteilhaft beispielsweise in einer Bipolar-CMOS-Kombinationstechnologie zusammen mit vertikalen NPN-Bipolartransistoren und komplementären N- und P-Kanal-Feldeffekttransistoren eingesetzt werden. Hierbei finden die anhand der Figuren 6a bis 6k erläuterten Bearbeitungsschritte Verwendung.

Auf einem p-leitenden Siliziumsubstrat 1 mit einem spezifischen Widerstand von 1 - 2 Ωcm wird gemäß Fig. 6a durch thermische Oxidation eine ca. 0,07 μm dicke Schicht 2 aus Siliziumoxid erzeugt. Darauf wird unter Verwendung bekannter Techniken eine 0,1 μm dicke Schicht 3 aus Siliziumnitrid erzeugt, deren oberste Schicht von 10 nm durch eine Temperaturbehandlung in Wasserdampf in Siliziumoxid umgewandelt wird. Durch Maskierung mit Fotolack 4 und Ätzung der Schicht 3 einschließlich ihrer umgewandelten Oberflächenschicht wird auf einem Teil der Oberfläche des Substrats eine gegen Oxidation maskierende Maske gebildet. Damit erhält man die Struktur nach Fig. 6a. In die in der Fotolackmaske geöffneten Fenster wird nun Arsen (oder Antimon) per Ionenimplantation eingebracht, wodurch n-leitende Halbleiterzonen angelegt werden.

Nach Entfernen der Fotolackmaske, wieder durch eine thermische Behandlung in Stickstoff werden die $n^+$-leitenden Halbleiterzonen 5a bis 5c gebildet. Anschließend werden die nicht mit dem Nitrid 3 bedeckten Oberflächenteile des Siliziums in feuchter Sauerstoffatmosphäre oxidiert, wobei ein teilweise in den Körper versenktes Oxidmuster 6 im Bereich der $n^+$-leitenden Halbleiterzone 5a bis 5c gebildet wird (Fig. 6b).

Darauf werden die unterschiedlich dicken Oxidbereiche 2 und 6 von der Oberfläche durch eine Ätzung in gepufferter Fluorwasserstofflösung entfernt. Die dabei entstehenden Stufen an der Oberfläche dienen zum Wiederfinden der $n^+$-dotierten Halbleiterzonen 5a bis 5c.

Nun wird gemäß Figur 6c unter Verwendung in der Halbleitertechnik üblicher Verfahren epitaktisch eine 5 μm dicke p-leitende Siliziumschicht 7 mit einem spezifischen Widerstand von ca. 20 Ωcm auf das Substrat 1 aufgewachsen. Darauf wird durch thermische Oxidation eine ca. 0,7 μm dicke Schicht 8 aus Siliziumoxid erzeugt. Durch einen ersten Maskierschritt werden in einer Photolackschicht Fenster erzeugt, durch die die $n^+$-leitenden Halbleiterzonen 10a, b oberhalb von Teilbereichen der Zonen 5b, 5c angelegt werden und zwar per Implantation von Phosphorionen (Dosis 1 - 5 • $10^{15}$ $cm^{-2}$). Durch einen zweiten Maskierschritt werden in einer neuen Photolackschicht 9 Fenster erzeugt, durch die per Implantation von Phosphorionen mit einer Dosis von ca. 1 - 3 • $10^{12}$ $cm^{-2}$ die n-leitenden Halbleiterzonen 12 oberhalb der Zonen 5a - 5c angelegt werden (Fig. 6d).

Bei der Ausbildung der Zonen 12 entstehen gleichzeitig die bis zu den vergrabenen $n^+$ Zonen 5b und 5c reichenden $n^+$ Anschlußzonen 10.

Auf der Siliziumoxidschicht 8 wird nun eine 0,1 μm dicke Schicht 11 aus Siliziumnitrid abgeschieden, deren oberste Schicht von ca. 10 nm wieder durch thermische Behandlung in Wasserdampf in Siliziumoxid umgewandelt wird. Durch Maskierung mit Fotolack 27 und Ätzung der Schicht 11 einschließlich ihrer umgewandelten Oberflächenschicht wird auf einem Teil der Oberfläche des Halbleiterkörpers eine gegen Oxidation maskierende Maske gebildet (Fig. 6d).

Anschließend wird die strukturierte Fotolackschicht 27 durch eine Temperaturbehandlung resistent gemacht und eine weitere Fotolackschicht 13 gemäß Figur 6e aufgebracht. Aus ihr werden Strukturen zur Abdeckung der n-leitenden Halbleiterzonen 5a - 5c während der jetzt folgenden Implantation von Borionen mit einer Dosis von 1 - 4 • $10^{13}$ $cm^{-2}$ in die p-leitende Oberflächenzonen in der Schicht 7 zur Vermeidung einer späteren Oberflächeninversion erzeugt (Fig. 6e). Dieser doppelte Fotolackschritt erlaubt eine Selbstjustierung der Feldimplantation mit den Zonen der aktiven Bauelemente im p-leitenden Oberflächenbereich.

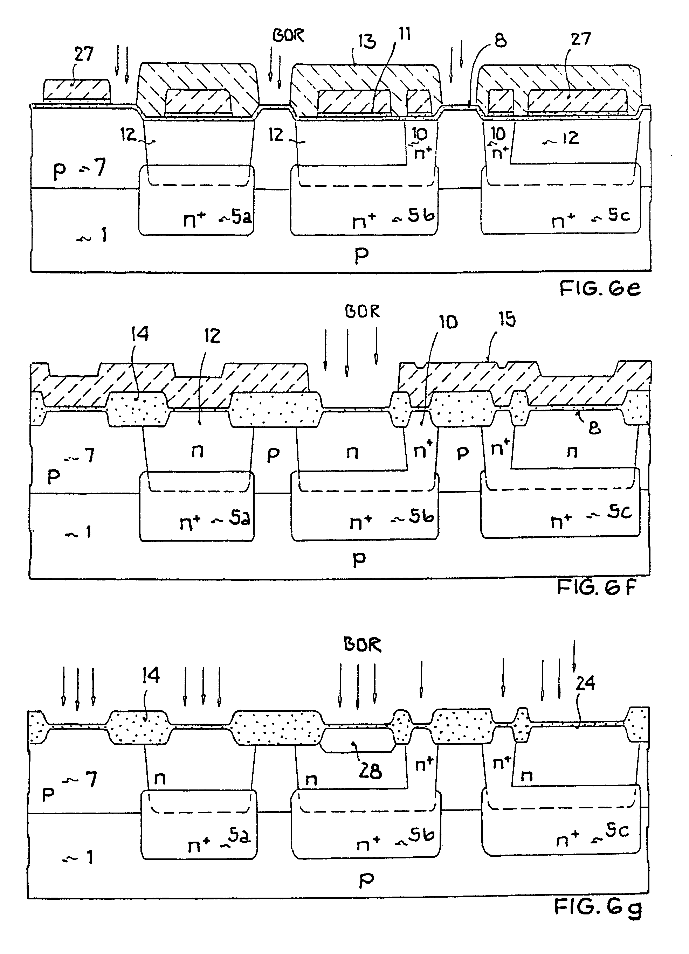

Nach Entfernen der doppelten Fotolackmaske 27, 13 werden die nicht mit Nitrid bedeckten Oberflächenteile des Siliziums in feuchter Sauerstoffatmosphäre oxidiert, wobei ein teilweise in den Körper versenktes Feldoxidmuster 14 gemäß Figur 6f gebildet wird.

Mit Hilfe einer Fotolackschicht 15 werden Fenster für die Basis der NPN-Transistoren gebildet und in diese Fenster Borionen mit einer Dosis von 8 • $10^{13}$ 4 • $10^{14}$ $cm^{-2}$ implantiert.

Danach wird die Lackschicht 15 entfernt und aus der implantierten Verunreinigung die p-leitenden Basiszonen 28 gebildet. Dies geschieht durch einen Diffusionsprozeß bei ca. 1050 °C in inerter Atmosphäre. Das dünne Oxid 8 wird ohne Maske abgenommen und anschließend eine Gateoxidschicht 24 in trockenem Sauerstoff unter Zugabe von HCl durch thermische Oxidation erzeugt (Fig. 6g).

Durch dieses Gateoxid 24 werden zur Einstellung der Schwellenspannung der Feldeffekttransistoren Borionen mit zwei verschiedenen Energien implantiert. Eine flache Implantation mit 30 - 50 kV Beschleunigungsspannung und eine tiefe Implantation mit 160 - 200 kV Beschleunigungsspannung. Durch Optimierung der Aufteilung der Gesamtdosis von ca. 4 - 7 • $10^{11}$ $cm^{-2}$ auf die beiden Implantationen kann für P- und N-Kanal-Feldeffekttransistoren eine symmetrische Schwellenspannung von - 0,8 V bzw. + 0,8 V eingestellt werden. Gleichzeitig wird dabei die Halbleiterzone 25 entsprechend Fig. 3 gebildet, welche dem PNP-Lateraltransistor nach der Erfindung die gewünschte Verstärkereigenschaft verleiht.

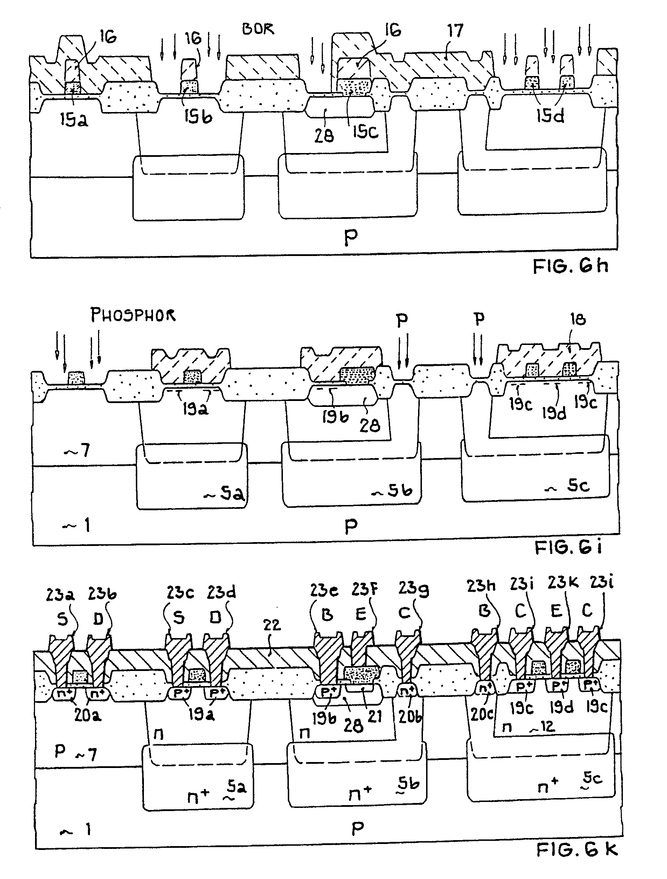

Danach wird gemäß Fig. 6h durch einen Fotolackschritt mit anschließendem Oxidätzschritt ein Durchbruch für den Emitter 15c des NPN-Transistors über der Basiszone 28 im Gateoxid gebildet. Darauf wird mit Hilfe eines bekannten LPCVD-Verfahrens eine undotierte Polysiliziumschicht abgeschieden und mit einer ganzflächigen Phosphorimplantation mit einer Dosis von 1 - 2 • $10^{16}$ cm$^{-2}$ n-leitend gemacht.

Durch Maskierung mit einem Fotolack 16 und anschließender Ätzung des Polysiliziums in einem Plasmareaktor werden die Gateelektroden 15a, 15b der Feldeffekttransistoren, die Emitterelektrode 15c des NPN-Bipolartransistors und der Polysiliziumring 15d für den lateralen PNP-Bipolartransistor gebildet (Fig. 6h).

Anschließend wird die strukturierte Fotolackschicht 16 durch eine Temperaturbehandlung resistent gemacht und eine weitere Fotolackschicht 17 aufgebracht.

In dieser Fotolackschicht 17 werden Fenster für die Source- und Drainzone des P-Kanal-Feldeffekttransistors 19a, für den Basisanschluß 19b des NPN-Transistors und für den Kollektor 19c und Emitter 19d des PNP-Transistors geöffnet und Borionen mit einer Dosis von 4 - 8 • $10^{15}$ cm$^{-2}$ implantiert. Das n-leitende Polysilizium 15a bis 15 d wird dabei durch die noch vorhandene Fotolackschicht 16 gegen das Eindringen von kompensierenden Borionen geschützt.

Nach Abnehmen der Fotolackschichten 16 und 17 wird eine neue Fotolackschicht 18 gemäß Fig. 6i aufgebracht und durch geöffnete Fenster die n$^+$leitende Source- und Drainzone 20 a (Fig. 6k) des N-Kanal-Feldeffekttransistors, der Kollektoranschluß 20b (Fig. 6k) des NPN-Transistors und der Basisanschluß 20c (Fig. 6k) des PNP-Transistors mit Phosphor- bzw. As-Ionen mit einer Dosis von 5 - 10 • $10^{15}$ cm$^{-2}$ implantiert.

Nach Abnehmen der Fotolackschicht 18 werden durch eine thermische Behandlung gleichzeitig die p$^+$-leitenden Gebiete 19a bis 19 d, die n$^+$-leitenden Gebiete 20a bis 20 c und der n$^+$-leitende Emitter 21 aus den eingebrachten Verunreinigungen ausgebildet (Fig. 6k). Auf der ganzen Anordnung wird nun eine ca. 0,8 µm dicke Oxidschicht 22 erzeugt, mit Kontaktlöchern versehen und schließlich eine Aluminiumschicht aufgedampft, in der durch einen fotolithografischen Ätzvorgang metallische Leiterbahnen 23a bis 23i für die Anschlüsse erzeugt werden.

Schließlich wird 30 min. lang bei 450 °C in Formiergas (N$_2$ + H$_2$) getempert, bevor die Eigenschaften der einzelnen Bauelemente gemessen werden können.

Die in Figur 6k dargestellte Anordnung enthält folglich von links nach rechts einen n-Kanal-Feldeffekttransistor, einen p-Kanal-Feldeffekttransistor, einen NPN-Vertikaltransistor und einen PNP-Lateraltransistor. Daraus ergibt sich, daß komplexe integrierte Schaltungen aufgebaut werden, die diese und andere Halbleiterbauelemente enthalten und wobei die erfindungsgemäß Lateraltransistoren vom PNP-Typ ohne zusätzliche Arbeitschritte mit dem Stromführungskanal zwischen der Kollektor-Zone und der Emitter-Zone versehen werden können.

## Ansprüche

1. PNP-Lateraltransistor aus zwei in die Oberfläche eines Halbleiterbereichs (12) vom ersten Leitungstyp eingelassenen, Emitter und Kollektor bildenden Zonen (19c, 19d) vom zweiten Leitungstyp, wobei der zwischen diesen beiden Zonen liegende Teil des Halbleiterbereichs vom ersten Leitungstyp die aktive Basiszone (26) bildet, und wobei die aktive Basiszone (26) unterhalb der Halbleiteroberfläche und angrenzend an die Emitter- und die Kollektorzone (19c bzw. 19d) eine vergrabene Halbleiterzone (25) enthält, die gegenüber dem übrigen umgebenden Bereich der aktiven Basiszone (26) zusätzliche kontradotierende Fremdatome enthält, wodurch die Minoritätsladungsträger in der aktiven Basiszone (26) im Abstand von der Halbleiteroberfläche zwischen der Emitterzone (19d) und der Kollektorzone (19c) konzentriert werden.

2. Lateraltransistor nach Anspruch 1, dadurch gekennzeichnet, daß die vergrabene Halbleiterzone (25) den ersten Leitungstyp aufweist, wobei die Dotierung gegenüber dem übrigen umgebenden Bereich dar Basiszone (26) erheblich reduziert ist.

3. Lateraltransistor nach Anspruch 1, dadurch gekennzeichnet, daß die vergrabene Halbleiterzone (25) den zweiten Leitungstyp aufweist, jedoch so schwach dotiert ist, daß keine Selbstleitung erfolgt.

4. Lateraltransistor nach einem der vorangehenden Ansprüche, dadurch gekennzeichnet, daß die vergrabene Halbleiterzone (25) durch Ionenimplantation erzeugt ist.

5. Lateraltransistor nach einem der vorangehenden Ansprüche, dadurch gekennzeichnet, daß die vergrabene Halbleiterzone (25) einen Abstand von ca. 0,3 µm von der Halbleiteroberfläche aufweist, bis zu einer Eindringtiefe von ca. 0,6 µm reicht und eine Dotierung zwischen $10^{14}$ bis $10^{16}$ Atomen/cm$^3$ vom n- bzw. p-Leitungstyp aufweist.

6. Lateraltransistor nach einem der vorangehenden Ansprüche, dadurch gekennzeichnet, daß die aktive Basiszone (26) an der Halbleiteroberfläche mit einer Passivierungsschicht (24) bedeckt ist, auf der eine mit dem Emitteranschluß (23m) verbundene Elektrodenschicht (15d) angeordnet ist.

7. Lateraltransistor nach Anspruch 6, dadurch gekennzeichnet, daß die Elektrodenschicht (15d) aus leitendem polykristallinem Silizium und die darunter angeordnete Passivierungsschicht (24) aus Siliziumdioxid oder Siliziumnitrid besteht.

8. Integrierte Halbleiterschaltung mit einem Lateraltransistor nach einem der vorangehenden Ansprüche, dadurch gekennzeichnet, daß er zusammen mit CMOS-Feldeffekttransistoren und NPN-Bipolartransistoren in einem allen Bauelementen gemeinsamen Halbleiterkörper (1) angeordnet ist.

9. Verfahren zur Herstellung einer integrierten Halbleiterschaltung nach Anspruch 8, dadurch gekennzeichnet, daß die vergrabene Halbleiterzone (25) in die aktive Basiszone (26) des Lateraltransistors durch die Ionenimplantation erzeugt wird, mit der die Schwellspannung der CMOS-Feldeffekttransistoren mittels Implantation von Ladungsträgern durch die die Halbleiteroberfläche jeweils bedeckende Gate-Passivierungsschicht (24) eingestellt wird.

10. Leistungsverstärker oder Eingangsverstärker mit einem Lateraltransistor nach den Ansprüchen 1 bis 7.

**Claims**

1. Lateral p-n-p transistor with, inset into the surface of a semiconductor region (12) of the first conduction type, two zones (19c, 19d) of the second conduction type forming emitter and collector, in which the part of the semiconductor region of the first conduction type lying between these two zones forms the active base zone (26), and in which the active base zone (26) contains below the semi-conductor surface and bordering on the emitter and collector zones (19c and 19d) a buried semiconductor zone (25) which compared with the rest of the surrounding region of the active base zone (26) contains additional counterdoping foreign atoms, whereby the minority charge carriers are concentrated in the active base zone (26) at a spacing from the semiconductor surface between the emitter zone (19d) and the collector zone (l9c).

2. Lateral transistor according to claim 1, characterized in that the buried semiconductor zone (25) is of the first conduction type, and the doping compared with the rest of the surrounding region of the base zone (26) is considerably reduced.

3. Lateral transistor according to claim 1, characterized in that the buried semiconductor zone (25) is of the second conduction type, but is so weakly doped that no selfconduction takes place.

4. Lateral transistor according to any one of the preceding claims, characterized in that the buried semiconductor zone (25) is produced by ion implantation.

5. Lateral transistor according to any one of the preceding claims, characterized in that the buried semiconductor zone (25) is situated at a distance of approx. 0.3 $\mu$m from the semiconductor surface, extends down to a penetration depth of approx. 0.6 $\mu$m and has a doping of between 10 to 10 atoms/cm$^3$ of the n- or p-conduction type.

6. Lateral transistor according to any one of the preceding claims, characterized in that the active base zone (26) is covered at the semiconductor surface with a passivation layer (24), on which an electrode layer (l5d) connected to the emitter terminal (23m) is arranged.

7. Lateral transistor according to claim 6, characterized in that the electrode layer (15d) consists of conductive polycrystalline silicon and the passivation layer (24) arranged thereunder consists of silicon dioxide or silicon nitride.

8. Integrated semiconductor circuit with a lateral transistor according to any one of the preceding claims, characterized in that it is arranged together with CMOS field-effect transistors and bipolar n-p-n transistors in a semiconductor body common to all components.

9. Method of manufacturing an integrated semiconductor circuit according to claim 8, characterized in that the buried semiconductor zone (25) is produced in the active base zone (26) of the lateral transistor by the ion implementation with which the threshold voltage of the CMOS field-effect transistors is set by means of implementation of charge carriers due to the respective gate passivation layer (24) covering the semiconductor surface.

10. Power amplifier or input amplifier with a lateral transistor according to claims 1 to 7.

**Revendications**

1. Transistor latéral PNP constitué de deux zones (l9c, l9d) formant un émetteur et un collecteur, encastrées dans la surface d'une région de semi-conducteur (12) ayant un premier type de conductivité, la partie de la région de semi-conducteur située entre ces deux zones, lesquelles ont le second type de conductivité, formant la zone de base active (26), dans lequel la zone de base active (26) contient, au-dessous de la surface du semi-conducteur et limitrophe aux zones d'émetteur et de collecteur (l9c et l9d), une zone de semi-conducteur enterrée (25) contenant des atomes d'impuretés supplémentaires de contre-dopage, vis-à-vis de la partie restante, environnante, de la zone de base active (26), de sorte que les porteurs minoritaires sont concentrées à distance de la surface du semi-conducteur dans la zone de base active (26), entre la zone d'émetteur (l9d) et la zone de collecteur (l9c).

2. Transistor latéral selon la revendication 1, caractérisé en ce que la zone de semi-conducteur enterrée (25) présente le premier type de conductivité, le dopage étant considérablement réduit par rapport à la partie restante, environnante, de la zone de base (26).

3. Transistor latéral selon la revendication 1, caractérisé en ce que la zone de semi-conducteur enterrée (25) présente le second type de conductivité, mais est dopée si faiblement qu'il n'y a pas d'auto-conduction.

4. Transistor latéral selon une des revendications précédentes, caractérisé en ce que la zone de semi-conducteur enterrée (25) est formée par implantation ionique.

5. Transistor latéral selon une des revendications précédentes, caractérisé en ce que la zone de semi-conducteur enterrée (25) se trouve à une distance d'environ 0,3 μm de la surface du semi-conducteur, s'étend jusqu'à une profondeur de pénétration d'environ 0,6 μm et possède un dopage compris entre $10^{14}$ et $10^{16}$ d'atomes/cm$^3$ du type de conductivité n ou p.

6. Transistor latéral selon une des revendications précédentes, caractérisé en ce que la zone de base active (26) est recouverte, à la surface du semi-conducteur, par une couche de passivation (24), sur laquelle est disposée une couche d'électrode (l5d) reliée à la borne d'émetteur (23m).

7. Transistor latéral selon la revendication 6, caractérisé en ce que la couche d'électrodes (l5d) est en silicium polycristallin conducteur et la couche de passivation (24) sous-jacente est en silice ou nitrure de silicium.

8. Circuit intégré à semi-conducteur, comportant un transistor latéral selon une des revendications précédentes, caractérisé en ce que le transistor latéral est disposé ensemble avec des transistor à effet de champ MOS complémentaires et des transistors bipolaires NPN dans un corps semi-conducteur (1) commun à tous les composants.

9. Procédé pour fabriquer un circuit intégré à semi-conducteur selon la revendication 8, caractérisé en ce que l'on forme la zone de semi-conducteur enterrée (25) dans la zone de base active (26) du transistor latéral, par l'implantation ionique au moyen de laquelle on ajuste la tension de seuil des transistors à effet de champ MOS complémentaires par implantation de porteurs de charge au travers de la couche de passivation de grille (24) recouvrant la surface du semi-conducteur.

10. Amplificateur de puissance ou amplificateur d'entrée comportant un transistor latéral selon les revendications 1 à 7.

FIG.1

FIG.2

FIG.3

KONZENTRATION

FIG. 4

ABSTAND VON DER OBERFLÄCHE

FIG. 5

FIG.6a

FIG.6b

FIG.6c

FIG.6d

FIG. 6e

FIG. 6F

FIG. 6g

FIG. 6h

FIG. 6i

FIG. 6k